(19) Europäisches Patentamt
European Patent Office
Office européen des brevets

(11) **EP 1 241 821 A1**

(12) **DEMANDE DE BREVET EUROPEEN**

(43) Date de publication:
**18.09.2002 Bulletin 2002/38**

(51) Int Cl.$^7$: **H04L 1/00**

(21) Numéro de dépôt: **02075835.5**

(22) Date de dépôt: **04.03.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **13.03.2001 FR 0103414**

(71) Demandeur: **Koninklijke Philips Electronics N.V. 5621 BA Eindhoven (NL)**

(72) Inventeur: **Delmas, Gilles, Soci-t- Civile S.P.I.D. 75008 Paris (FR)**

(74) Mandataire: **de la Fouchardière, Marie-Noelle Société Civile "SPID" 156, Boulevard Haussmann 75008 Paris (FR)**

(54) **Procédé de protection de paquets de données contre des erreurs**

(57) L'invention propose un procédé de protection de paquets de données contre des erreurs qui consiste à élaborer S paquets de correction d'erreurs pour N paquets de données, un paquet de correction d'erreurs $Y_i$ (où i est un entier naturel compris entre 0 et S-1) étant élaboré à partir des N/S paquets de données $X_{i+jS}$ (j=0,...,N/S-1).

L'invention permet de récupérer jusqu'à S paquets de données consécutifs perdus lors de la transmission dès lors que l'écart entre deux groupes de paquets consécutifs perdus est supérieur à N.

Application : transmission sans fil via Internet notamment ; protocoles RTP/UDP/IP.

FIG.4

EP 1 241 821 A1

**Description**

Domaine de l'invention

La présente invention concerne un système comportant au moins une entité source et une entité destination, ladite entité source étant destinée à délivrer des paquets de données et des paquets de correction d'erreurs à ladite entité destination.

Elle concerne également un émetteur destiné à transmettre des paquets de données et des paquets de correction d'erreurs, et un récepteur destiné à recevoir des paquets de données et des paquets de correction d'erreurs, et comportant au moins des moyens de détection de perte de paquets de données et des moyens de récupération de paquets de données.

Elle concerne aussi un procédé de protection de paquets de données contre des erreurs, un procédé de récupération de paquets perdus, et des programmes d'ordinateur comportant des instructions pour la mise en oeuvre desdits procédés.

Elle concerne enfin un flux de paquets de correction d'erreurs.

L'invention a d'importantes applications dans le domaine des transmissions par paquets. Elle s'applique par exemple à la transmission de données via l'Internet, et en particulier à la transmission de données via l'Internet basé sur des réseaux d'accès sans fil.

Arrière plan technologique de l'invention

Le document « Request For Comment 2733 » publié par l'IETF (de l'anglais Internet Engineering Task Force) décrit un exemple de mécanisme de protection contre les erreurs connu sous le nom de FEC (de l'anglais Forward Error Correction). Le mécanisme FEC consiste à ajouter de la redondance aux données transmises. Cette redondance est transmise dans des paquets de correction d'erreurs (également appelés paquets FEC). Elle permet, à la réception, de reconstituer des paquets perdus pendant le transport. Dans la RFC 2733, les paquets FEC sont élaborés en appliquant une opération OU exclusif à plusieurs paquets de données. Plusieurs schémas d'élaboration de paquets FEC sont proposés au paragraphe 4 de la RFC 2733.

Résumé de l'invention

Un but de l'invention est de proposer un autre schéma, qui soit particulièrement efficace lorsque les erreurs risquent de toucher plusieurs paquets consécutifs, ce qui est le cas notamment dans les transmissions sans fil, du fait de la mauvaise qualité des liaisons radio.

Ce but est atteint avec un système selon l'invention et tel que décrit dans le paragraphe introductif, dans lequel S paquets de correction d'erreurs $Y_0,...,Y_{S-1}$ sont fournis pour N paquets de données $X_0,...X_{N-1}$, un paquet de correction d'erreurs $Y_i$ (où i est un entier naturel compris entre 0 et S-1) étant élaboré à partir des N/S paquets de données $X_{i+jS}$ avec j=0,...,N/S-1.

Le schéma proposé par l'invention permet de récupérer (ou reconstruire) jusqu'à S paquets consécutifs, dès lors que la distance entre deux groupes de paquets à récupérer est supérieure à N.

Un émetteur selon l'invention comporte des moyens pour élaborer un paquet de correction d'erreurs $Y_i$ (où i est un entier naturel compris entre 0 et S-1) à partir des N/S paquets de données $X_{i+jS}$ (j=0,...,N/S-1), et des moyens pour transmettre S paquets de correction d'erreurs $Y_0,...,Y_{S-1}$ pour N paquets de données $X_0,...X_{N-1}$.

Pour récupérer un paquet de données $X_k$ avec k=i+pS (où i, p et S sont des entiers naturels, un récepteur selon l'invention utilise N/S-1 paquets de données $X_{i+jS}$ avec j=0,...,N/S-1 et j≠p, et un paquet de correction d'erreur $Y_i$ qui est fonction des N/S paquets de données $X_{i+jS}$ (j=0,...,N/S-1).

Dans un mode de réalisation avantageux de l'invention, lesdits paquets de données d'une part et lesdits paquets de correction d'erreurs d'autre part constituent deux flux de paquets distincts fournis et susceptibles d'être obtenus indépendamment l'un de l'autre. Ce mode de réalisation permet à un récepteur de recevoir le flux de paquets de données seulement, ou le flux de paquets de données et le flux de paquets de correction d'erreurs, selon que le récepteur sait ou non exploiter le flux de paquets de correction d'erreurs, ou selon qu'il a ou non besoin de recevoir ce flux.

Un flux de paquets de correction d'erreurs selon l'invention comporte des paquets $Y_i$ qui sont une combinaison de N/S paquets de données $X_{i+jS}$ (j=0,..., N/S-1), où i, N, S et N/S sont des entiers naturels.

Brève description des dessins

L'invention sera mieux comprise et d'autres détails apparaîtront dans la description qui va suivre en regards des dessins annexés qui sont donnés à titre d'exemples non limitatifs et dans lesquels :

- la figure 1 est un schéma d'un exemple de système selon l'invention,
- la figure 2 est un schéma d'un datagramme IP/UDP/ RTP,
- la figure 3 est un schéma décrivant le fonctionnement d'un exemple d'émetteur selon l'invention,
- la figure 4 est un schéma décrivant le fonctionnement d'un exemple de récepteur selon l'invention.

Description d'un mode de réalisation préférentiel de l'invention

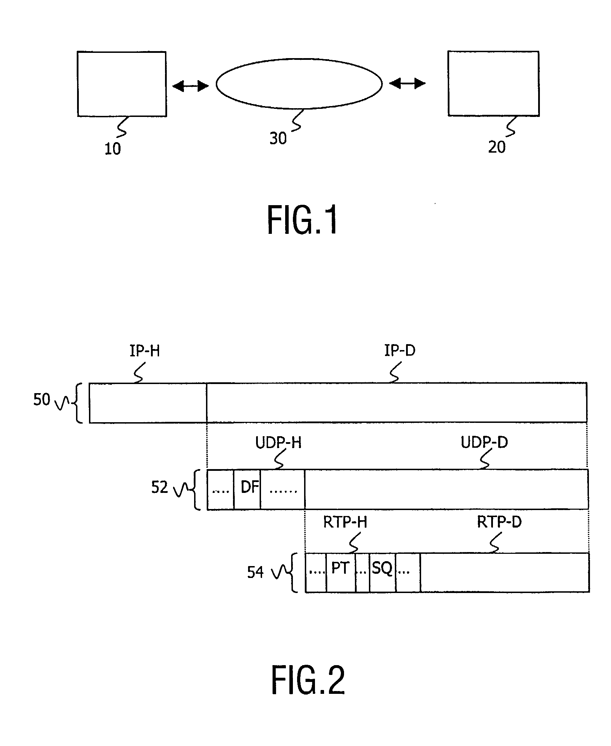

Sur la figure 1, on a représenté à titre d'exemple un système selon l'invention qui comporte une entité source et une entité destination. Dans cet exemple, l'entité source est un émetteur 10 et l'entité destination est un récepteur 20. L'émetteur 10 et le récepteur 20 sont reliés par un canal de transmission 30, comportant par exemple un canal radio. Dans l'exemple qui va être décrit, le protocole de transport utilisé est le protocole RTP sur UDP sur IP. Ceci n'est pas limitatif. RTP (Real time Transport Protocol) et UDP (User Datagram Protocol) sont des protocoles de la couche transport définis dans les RFC 1889 et 0768 de l'IETF respectivement. Le protocole IP (Internet Protocol) est un protocole de la couche réseau défini, pour la version 4 par la RFC 0791, et pour la version 6 par la RFC 1883 de l'IETF. Dans la suite on ne décrira que les éléments nécessaires à la compréhension de l'invention. Pour plus de détails, on se reportera aux RFC précitées.

Sur la figure 2, on a représenté un datagramme IP qui contient un datagramme UDP contenant lui-même un paquet RTP.

D'après la figure 2, un datagramme IP portant la référence 50 comporte un entête IP-H et un champ de données IP-D. Le champ de données IP-D contient un datagramme UDP portant la référence 52. Le Datagramme UDP 52 contient un entête UDP-H et un champ de données UDP-D. Le champ de données UDP-D contient un paquet RTP qui porte la référence 54. Ce paquet RTP 54 contient un entête RTP-H et un champ de données RTP-D.

Lorsque le paquet RTP est un paquet de données, le champ de données RTP-D contient des données utiles, par exemple des données encodées délivrées par un encodeur vidéo MPEG-4. Lorsque le paquet RTP est un paquet de correction d'erreurs, le champ de données RTP-D contient des données de correction d'erreurs.

L'entête RTP-H du paquet RTP contient, entre autres, un champ de type, noté PT, qui indique le type des données contenues dans le champ de données RTP-D, et un champ de numéro de séquence, noté SQ, qui est incrémenté d'une unité à chaque fois qu'un paquet RTP est envoyé de façon à permettre au récepteur de détecter la perte d'un paquet.

L'entête UDP-H du datagramme UDP contient, entre autres, un champ destination DF qui indique le port destination du datagramme UDP.

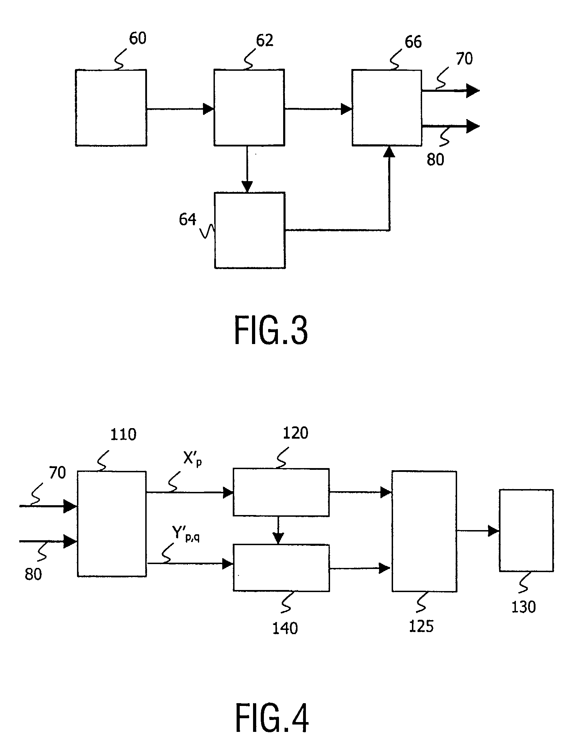

La RFC 2773 de l'IETF décrit le format du champ de données RTP-D d'un paquet de correction d'erreurs, appelé paquet FEC. D'après la RFC 2773, le champ de données RTP-D d'un paquet FEC comporte un entête FEC noté FEC-H, suivi d'un champ de données FEC noté FEC-D. L'entête FEC-H contient, entre autres, un champ SN et un champ MASK. Le champ SN indique le numéro de séquence de base M des paquets de données protégés par ce paquet FEC. Le champ MASK est un champ de 24 bits. Lorsqu'un bit i du champ MASK est positionné à « 1 », cela signifie que le paquet de données ayant comme numéro séquence M+i [modulo 65536] est protégé par ce paquet FEC. Sur la figure 3 on a représenté un schéma décrivant le fonctionnement de l'émetteur 10. D'après la figure 3, un bloc d'encodage 60 fournit des données encodées à un bloc 62 de mise en paquets. Le bloc 62 de mise en paquets délivre des paquets de données RTP notés $X_p$ (p étant un entier naturel). Ces paquets de données $X_p$ sont fournis d'une part à un bloc 64 d'élaboration de paquets de correction d'erreurs, et d'autre part à un bloc de transmission 66. Le bloc 64 d'élaboration de paquets de correction d'erreurs élabore S paquets de correction d'erreurs $Y_{p,q}$, avec q=0,...,S-1 pour N paquets de données $X_p$,... $X_{p+N-1}$. Conformément à l'invention, chaque paquet de correction d'erreurs $Y_{p,q}$ est élaboré à partir des N/S paquets de données $X_{p+q+jS}$ avec j=0,...,N/S-1.

Les paquets de correction d'erreurs $Y_{p,q}$ sont ensuite fournis au bloc de transmission 66 qui encapsule les paquets RTP dans des datagrammes UDP, eux-mêmes encapsulés dans des datagrammes IP, et transmet les datagrammes IP qui en résultent.

De façon avantageuse, le bloc de transmission 66 délivre deux flux distincts, un flux 70 relatifs aux paquets de données et un flux 80 relatif aux paquets de correction d'erreurs. Dans la pratique, ces deux flux correspondent à deux sessions RTP différentes, c'est-à-dire à deux ports de destination DF différents dans les datagrammes UDP.

Lorsque les paquets de données et les paquets de correction d'erreurs constituent un unique flux transmis dans une même session, les paquets de correction d'erreurs doivent être transmis après les N paquets de données auxquels ils se rapportent pour permettre effectivement de corriger jusqu'à S pertes consécutives. Dans ce cas, le champ de type PT est avantageusement utilisé pour distinguer les paquets de données des paquets de correction d'erreurs.

Sur la figure 4 on a représenté un schéma décrivant le fonctionnement du récepteur 20. D'après la figure 4, un bloc de réception 110 reçoit les flux 70 et 80 et délivre des paquets de données $X'_p$ et des paquets de correction d'erreurs $Y'_{p,q}$. Un bloc de détection 120 vérifie les numéros de séquence SQ contenus dans les entêtes de paquets de données pour détecter d'éventuelles pertes de paquets de données. Les paquets de données sont ensuite fournis à un bloc 125 de reconstruction de flux. Lorsque le bloc de détection 120 détecte qu'un paquet de données $X'_m$ (m=i+kS=aN+b où i, k, a et b sont des entiers naturels) a été perdu, un bloc de récupération 140 exécute des opérations de récupérations du paquet de données à partir des N/S-1 paquets de données $X'_{i+jS}$ avec j=0,...,N/S-1 et j≠k, et à partir du paquet de correction d'erreurs $Y'_{a,i}$ (le champ SN et le champ MASK de l'entête du paquet de correction d'erreurs $Y'_{a,i}$ indiquent les paquets de données à utiliser). Ces opérations de récupération sont menées à bien si les paquets de données $X'_{i+jS}$ (j=0,...,N/S-1et j≠k) et le paquet de correction d'erreur $Y'_{a,i}$ ont été correctement reçus. Dans ce cas, le paquet récupéré est transmis au bloc de reconstruction de flux 125. Le bloc de reconstruction de flux 125 reconstruit un flux de paquet de données, en insérant les paquets reconstitués par le bloc 140 dans le flux de paquets de données issus du bloc 120. Le flux reconstitué est ensuite fourni à un bloc applicatif (un bloc de décodage MPEG-4 dans cet exemple) référencé 130. En revanche, si un ou plusieurs paquets de données $X'_{i+jS}$ (j=0,...,N/S-1 et j≠k) ou si le paquet de correction d'erreur $Y'_{a,i}$ n'a pas été reçu correctement, le paquet de données perdu $X'_m$ ne peut pas être récupéré.

Finalement, le bloc de récupération 140 est donc capable de récupérer jusqu'à S paquets consécutifs au maximum, à condition que la distance entre les groupes de paquets perdus soit supérieure à N (il est évidemment possible que seuls certains paquets du groupe soient perdus : en fait le bloc 140 est capable de récupérer un nombre quelconque, inférieur ou égal à S, de paquets consécutifs ou non consécutifs, à condition que la distance entre les groupes de paquets perdus soit supérieure à N). Les entiers S et N doivent donc être choisis en fonction du nombre de paquets consécutifs susceptibles d'être perdus, de la distance probable entre deux groupes de paquets perdus et du taux de protection souhaité (pour régler le taux de protection, N peut être réduit ou augmenté).

D'une façon générale, lorsqu'on ajoute S paquets de correction d'erreurs pour N paquets de données, on augmente le nombre de paquets à transmettre de (S/N)%.

On va maintenant donner un exemple d'élaboration de paquets de correction d'erreurs et un exemple de récupération de paquets perdus dans un cas particulier, afin d'illustrer ce qui vient d'être décrit. Dans cet exemple on choisit N=24 et S=3. Soient $X_0$, $X_2$, ...., $X_{23}$, vingt-quatre paquets de données consécutifs. Les paquets de correction d'erreurs correspondants à ces 24 paquets de données sont les 3 paquets $Y_{0,0}$, $Y_{0,1}$ et $Y_{0,2}$ obtenus de la façon suivante:

$$Y_{0,0} = X_0 \oplus X_3 \oplus X_6 \oplus X_9 \oplus X_{12} \oplus X_{15} \oplus X_{18} \oplus X_{21}$$

$$Y_{0,1} = X_1 \oplus X_4 \oplus X_7 \oplus X_{10} \oplus X_{13} \oplus X_{16} \oplus X_{19} \oplus X_{22}$$

$$Y_{0,2} = X_2 \oplus X_5 \oplus X_8 \oplus X_{11} \oplus X_{14} \oplus X_{17} \oplus X_{20} \oplus X_{23}$$

Par exemple, si un ou plusieurs des trois paquets consécutifs $X_6$, $X_7$ et $X_8$ sont perdus :

- le paquet $X_6$ sera récupéré à partir des paquets de données $X_0$, $X_3$, $X_9$, $X_{12}$, $X_{15}$, $X_{18}$ et $X_{21}$, et à partir du paquet de correction d'erreur $Y_{0,0}$
- le paquet $X_7$ sera récupéré à partir des paquets de données $X_1$, $X_4$, $X_{10}$, $X_{13}$, $X_{16}$, $X_{19}$ et $X_{22}$, et à partir du paquet de correction d'erreur $Y_{0,1}$
- le paquet $X_8$ sera récupéré à partir des paquets de données $X_2$, $X_5$, $X_{11}$, $X_{14}$, $X_{17}$, $X_{20}$ et $X_{23}$, et à partir du paquet de correction d'erreur $Y_{0,2}$.

Dans ce cas particulier l'augmentation du nombre de paquets transmis du fait de la protection FEC est de 12,5%.

Le nombre N peut être supérieur à 24, bien que le champ MASK ne contienne que 24 bits. A titre d'exemple, on peut choisir N=25 et S=5. Dans ce cas, 5 paquets de correction d'erreurs $Y_{0,0}$, $Y_{0,1}$, $Y_{0,2}$, $Y_{0,3}$, et $Y_{0,4}$ sont formés à partir des 25 paquets de données $X_0$, $X_2$, ...., $X_{24}$:

$$Y_{0,0} = X_0 \oplus X_5 \oplus X_{10} \oplus X_{15} \oplus X_{20}$$

$$Y_{0,1} = X_1 \oplus X_6 \oplus X_{11} \oplus X_{16} \oplus X_{21}$$

$$Y_{0,2} = X_2 \oplus X_7 \oplus X_{12} \oplus X_{17} \oplus X_{22}$$

$$Y_{0,3} = X_3 \oplus X_8 \oplus X_{13} \oplus X_{18} \oplus X_{23}$$

$$Y_{0,4} = X_4 \oplus X_9 \oplus X_{14} \oplus X_{19} \oplus X_{24}$$

Dans ce cas, les champs SN des paquets de correction d'erreurs $Y_{0,0}$ et $Y_{0,4}$ ne contiennent pas le même numéro de séquence de base : le champ SN du paquet $Y_{0,0}$ contient le numéro de séquence du paquet $X_0$ ; et le champ SN du paquet $Y_{0,4}$ contient le numéro de séquence du paquet $X_4$.

L'invention n'est pas limitée au mode de réalisation qui vient d'être décrit à titre d'exemple. En particulier :

- Elle n'est pas limitée à l'utilisation d'une opération OU exclusif pour élaborer les paquets de correction d'erreurs. Elle est applicable à tout type de code correcteur d'erreur, notamment aux codes convolutifs ou aux codes en blocs.
- Il est possible d'utiliser une autre couche de transport de paquets que UDP/IP. Par exemple, lorsque la transmission se fait conformément à la norme Bluetooth, la couche de transport utilisée est L2CAP. L'invention n'est pas non plus limitée à l'utilisation du protocole RTP.
- La présence d'un bloc d'encodage n'est pas obligatoire. On peut protéger des données non encodées, par exemple du texte.

Dans le mode de réalisation qui vient d'être décrit, les paquets de correction d'erreurs portent sur des paquets entiers de données. Mais l'invention s'applique aussi lorsqu'on utilise une protection à plusieurs niveaux telle que décrite par exemple dans le document « An RTP Payload Format for Generic FEC with Uneven Level Protection » publié par l'IETF le 15 novembre 2000. Dans ce cas, les paquets de correction d'erreurs portent sur un morceau seulement de chaque paquet de données et non plus sur les paquets entiers. La longueur des morceaux utilisés pour calculer un paquet de correction d'erreurs peut varier en fonction de l'importance des données contenues dans les paquets de données à protéger.

Enfin, l'invention a été décrite dans le cas d'une transmission radio entre deux équipements distants. Mais elle est également applicable à une entité source constituée par un support de stockage de données, et à une destination constituée par un équipement de lecture du contenu dudit support. Dans ce cas les erreurs ne sont pas introduites par un canal de transmission, mais par l'opération de lecture elle-même.

**Revendications**

1. Système comportant au moins une entité source et une entité destination, ladite entité source étant destinée à délivrer des paquets de données et des paquets de correction d'erreurs à ladite entité destination, **caractérisé en ce que** S paquets de correction d'erreurs $Y_0,...,Y_{S-1}$ sont fournis pour N paquets de données $X_0,...X_{N-1}$, un paquet de correction d'erreurs $Y_i$ (où i est un entier naturel compris entre 0 et S-1) étant élaboré à partir des N/S paquets de données $X_{i+jS}$ avec j=0,...,N/S-1.

2. Système selon la revendication 1, **caractérisé en ce que** lesdits paquets de données d'une part et lesdits paquets de correction d'erreurs d'autre part constituent deux flux de paquets distincts fournis et susceptibles d'être obtenus indépendamment l'un de l'autre.

3. Emetteur destiné à transmettre des paquets de données et des paquets de correction d'erreurs, **caractérisé en ce qu'**il comporte des moyens pour élaborer un paquet de correction d'erreurs $Y_i$ (où i est un entier naturel compris entre 0 et S-1) à partir des N/S paquets de données $X_{i+jS}$ (j=0,...,N/S-1), et des moyens pour transmettre S paquets de correction d'erreurs $Y_0,...,Y_{S-1}$ pour N paquets de données $X_0,...X_{N-1}$.

4. Emetteur selon la revendication 3, **caractérisé en ce qu'**il comporte des moyens pour constituer un flux de paquets de données et un flux de paquets de correction d'erreurs distinct l'un de l'autre, lesdits flux étant destinés à être transmis indépendamment l'un de l'autre.

5. Récepteur destiné à recevoir des paquets de données et des paquets de correction d'erreurs, comportant au moins des moyens de détection de perte de paquets de données et des moyens de récupération de paquets de données et **caractérisé en ce que**, pour récupérer un paquet de données $X_k$ avec k=i+pS (où i, p et S sont des entiers naturels), lesdits moyens de récupération utilisent un paquet de correction d'erreur $Y_i$ qui est fonction de N/S paquets de données $X_{i+jS}$ (j=0,...,N/S-1), et N/S-1 paquets de données $X_{i+jS}$ avec j=0,...,N/S-1 et j≠p.

6. Procédé de protection de paquets de données contre des erreurs, comportant une étape d'élaboration de paquets de correction d'erreurs à partir desdits paquets de données, et une étape de délivrance desdits paquets de correction d'erreurs, **caractérisé en ce que** ladite étape d'élaboration de paquets de correction d'erreurs consiste à élaborer un paquet de correction d'erreurs $Y_i$ (où i est un entier naturel compris entre 0 et S-1) à partir des N/S paquets de données $X_{i+jS}$ (j=0,...,N/S-1), ladite étape de délivrance consistant à délivrer S paquets de correction d'erreurs $Y_0,...Y_{S-1}$ pour N paquets de données $X_0,...X_{N-1}$.

7. Procédé de protection de paquets de données contre des erreurs selon la revendication 6, **caractérisé en ce qu'**il comporte une étape de constitution d'un flux de paquets de données et d'un flux de paquets de correction d'erreurs distinct l'un de l'autre, lesdits flux étant destinés à être délivrés indépendamment l'un de l'autre.

8. Produit programme d'ordinateur comportant des instructions pour la mise en oeuvre d'un procédé de protection de paquets de données contre des erreurs selon l'une des revendications 6 ou 7.

9. Procédé de récupération de paquets de données perdus, à partir de paquets de données et de paquets de correction d'erreurs corrects, **caractérisé en ce qu'**il consiste à utiliser pour récupérer un paquet de données $X_k$ où k=i+pS (où i, p et S sont des entiers naturels), un paquet de correction d'erreur $Y_i$ qui est fonction de N/S paquets de données $X_{i+jS}$ (j=0,...,N/S-1), et N/S-1 paquets de données $X_{i+jS}$ avec j=0,...,N/S-1et j≠p.

10. Produit programme d'ordinateur comportant des instructions pour la mise en oeuvre d'un procédé de récupération de paquets de données selon la revendication 9.

11. Flux de paquets de correction d'erreurs dont les paquets $Y_i$ sont une combinaison de N/S paquets de données $X_{i+jS}$ (j=0,...,N/S-1), i, N, S et N/S étant des entiers naturels.

FIG.1

FIG.2

FIG.3

FIG.4

Office européen
des brevets

**RAPPORT DE RECHERCHE EUROPEENNE**

Numéro de la demande

EP 02 07 5835

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | CHIH-LIN I ET AL: "TRANSPARENT SELF-HEALING COMMUNICATION NETWORKS VIA DIVERSITY CODING" INTERNATIONAL CONFERENCE ON COMMUNICATIONS. INCLUDING SUPERCOMM TECHNICAL SESSIONS. ATLANTA, APR. 15 - 19, 1990, NEW YORK, IEEE, US, vol. 2, 15 avril 1990 (1990-04-15), pages 509-514, XP000146116 * abrégé; figure 3 * * page 308.6.2, colonne de gauche, ligne 22 - ligne 26 * * page 308.6.3, colonne de gauche, ligne 39 - colonne de droite, ligne 20 * | 1-11 | H04L1/00 |
| A | US 3 685 016 A (EACHUS JOSEPH J) 15 août 1972 (1972-08-15) * abrégé * * colonne 3, ligne 15 - ligne 25 * * colonne 5, ligne 34 - ligne 49 * * colonne 6, ligne 25 - ligne 41 * * colonne 7, ligne 19 - ligne 35 * * colonne 10, ligne 47 - ligne 51 * * colonne 12, ligne 8 - ligne 11 * | 1-11 | |
| | | | **DOMAINES TECHNIQUES RECHERCHES (Int.Cl.7)** |
| | | | H04L |

Le présent rapport a été établi pour toutes les revendications

| Lieu de la recherche | Date d'achèvement de la recherche | Examinateur |
|---|---|---|
| LA HAYE | 12 avril 2002 | Papantoniou, A |

## ANNEXE AU RAPPORT DE RECHERCHE EUROPEENNE
## RELATIF A LA DEMANDE DE BREVET EUROPEEN NO.

EP 02 07 5835

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-04-2002

| Document brevet cité au rapport de recherche | Date de publication | Membre(s) de la famille de brevet(s) | Date de publication |
|---|---|---|---|
| US 3685016 A | 15-08-1972 | BE 757116 A1 | 16-03-1971 |
| | | CA 918293 A1 | 02-01-1973 |
| | | CH 538791 A | 30-06-1973 |
| | | DE 2048365 A1 | 06-05-1971 |
| | | FR 2065561 A5 | 30-07-1971 |
| | | GB 1318250 A | 23-05-1973 |
| | | JP 50024819 B | 19-08-1975 |
| | | NL 7014496 A | 04-05-1971 |
| | | SE 364838 B | 04-03-1974 |

EPO FORM P0460

Pour tout renseignement concernant cette annexe : voir Journal Officiel de l'Office européen des brevets, No.12/82